(19)

Europäisches
Patentamt
European
Patent Office
Office européen
des brevets

(11) **EP 4 397 487 A1**

(12) **EUROPEAN PATENT APPLICATION**
published in accordance with Art. 153(4) EPC

(43) Date of publication:
**10.07.2024 Bulletin 2024/28**

(21) Application number: **22864684.0**

(22) Date of filing: **01.09.2022**

(51) International Patent Classification (IPC):
**B32B 27/12** (2006.01)    **C08J 5/18** (2006.01)
**B32B 15/08** (2006.01)    **B29C 48/21** (2019.01)
**B29C 48/25** (2019.01)    **H05K 1/03** (2006.01)

(52) Cooperative Patent Classification (CPC):
**B29C 48/21; B29C 48/25; B32B 15/08;
B32B 27/12; C08J 5/18; H05K 1/03**

(86) International application number:
**PCT/JP2022/032930**

(87) International publication number:
**WO 2023/033102 (09.03.2023 Gazette 2023/10)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **03.09.2021 JP 2021144054**

(71) Applicant: **Denka Company Limited
Tokyo 103-8338 (JP)**

(72) Inventors:
• **ISHIZUKA, Ryota**
  **Tokyo 103-8338 (JP)**
• **MASUDA, Yusuke**
  **Tokyo 103-8338 (JP)**
• **OGAWA, Naoki**
  **Tokyo 103-8338 (JP)**

(74) Representative: **Zacco Sweden AB
P.O. Box 5581
Löjtnantsgatan 21
114 85 Stockholm (SE)**

(54) **LCP EXTRUDED FILM, INSULATING MATERIAL FOR CIRCUIT BOARD, AND METAL FOIL CLAD LAMINATE**

(57)    To provide, for example, a novel LCP extruded film having high metal foil peel strength, and an insulating material for a circuit substrate and a metal foil-clad laminate each using the LCP extruded film, as well as a novel method for manufacturing an LCP extruded film having high metal foil peel strength. An LCP extruded film having a film surface S1 and comprising a thermoplastic liquid crystal polymer, wherein a contact angle $\sigma_1$ of the film surface S1 of the LCP extruded film with water after one day from constant temperature and humidity treatment at 23°C and 50% RH is 60° or more and 80° or less, a contact angle $\sigma_7$ of the film surface S1 of the LCP extruded film with water after 7 days from constant temperature and humidity treatment at 23°C and 50% RH is 60° or more and 80° or less, and a rate of decrease (($\sigma_7$ - $\sigma_1$)/$\sigma_1$) of the contact angle $\sigma_7$ relative to the contact angle $\sigma_1$ is 10.0% or less.

[Figure 1]

**Description**

Technical Field

The present invention relates to an LCP extruded film, an insulating material for a circuit substrate, and a metal foil-clad laminate.

Background Art

A composite impregnated with varnish has been conventionally known as an insulating material for a circuit substrate, the composite being formed by impregnating a glass cloth with a varnish comprising a thermosetting resin such as an epoxy resin and an inorganic filler and then subjecting the resultant to heat press molding. However, such a procedure is poor in process tolerance during manufacturing and inferior in productivity from the viewpoint of, for example, resin fluidity during impregnation with varnish and curing ability during heat press molding. A thermosetting resin easily absorbs moisture, and is changed in dimension along with such moisture absorption, and the obtained composite impregnated with varnish is inferior in dimensional accuracy (heating dimensional accuracy).

Liquid crystal polymers (LCP) are polymers that exhibit liquid crystallinity in a molten state or a solution state. Especially, thermotropic liquid crystal polymers that exhibit liquid crystallinity in a molten state can be extruded and have excellent properties such as high gas barrier properties, high film strength, high heat resistance, high insulation properties, low water absorption, and low dielectric characteristics in a high frequency area. Therefore, films using thermoplastic liquid crystal polymers are studied to come into practical use in gas barrier film material applications, electronic material applications, and electrically insulating material applications.

However, it has been found that, when single layer extrusion is actually performed, a thermoplastic liquid crystal polymer film high in industrial availability, namely, a thermoplastic liquid crystal polymer film excellent in thickness accuracy and favorable in appearance and surface flatness is difficult to obtain due to a high degree of liquid crystal alignment of a thermoplastic liquid crystal polymer.

For example, Patent Literature 1 discloses a method for manufacturing a liquid crystal film by use of a three layer co-extrusion die, in which an intermediate layer is a thermotropic liquid crystal resin layer including an aromatic polyester liquid crystal resin, an outer layer is a thermoplastic resin layer including a polypropylene resin or polyethylene, and the method includes co-extruding each layer by a three layer co-extrusion die, then releasing the thermoplastic resin layer as the outer layer, and taking the liquid crystal resin layer as the intermediate layer to form a film.

Citation List

Patent Literature

Patent Literature 1: Japanese Patent Laid-Open No. 63-31729

Summary of Invention

Technical Problem

An insulating material for a circuit substrate using a liquid crystal polymer has excellent high frequency characteristics and low dielectric properties, and therefore has been spotlighted in recent years as an insulating material for a circuit substrate such as flexible printed wiring boards (FPC), flexible printed wiring board laminates, and fiber reinforced flexible laminates in the fifth-generation mobile communication system (5G), millimeter wave radar, and the like that will be developed in the future. Specifically, such a thermoplastic liquid crystal polymer film, which is provided with metal foil such as copper foil by thermocompression bonding on one surface and/or both surfaces of the film, may be used as a metal foil-clad laminate in an application of an insulating material of a circuit substrate. This metal foil can be subjected to pattern etching or the like and thus be in the form of micro wiring or the like, and therefore, a metal foil-clad laminate can be used as, for example, a material of a circuit substrate such as an electronic circuit substrate or a multilayer substrate. In the application, adhesiveness between the thermoplastic liquid crystal polymer film and the metal foil is high, and high copper foil peel strength is required.

It is considered that the technique described in Patent Literature 1 can realize a thermoplastic liquid crystal polymer film excellent in thickness accuracy and favorable in appearance and surface flatness. However, in fact, there has been studied use of a metal foil-clad laminate in an insulating material, and it has thus found that the technique described in Patent Literature 1 does not allow adhesiveness between the thermoplastic liquid crystal polymer film and metal foil to be sufficient and has a difficulty in providing high metal foil peel strength. It is also here considered that the thermoplastic liquid crystal polymer film is subjected to various known physical surface treatments, for example, oxygen plasma treatment, ozone treatment, or corona discharge treatment in order to enhance adhesiveness between the thermoplastic liquid crystal polymer film and metal foil. However, the effect of enhancing adhesiveness by such surface treatment is temporarily exerted, and is significantly deteriorated over time after such treatment. Thus, it is necessary for obtaining high copper foil peel strength by such surface treatment to compression bond the thermoplastic liquid crystal polymer film and copper foil rapidly after such surface treatment in consideration of degradation over time.

The present invention has been made in view of the above problems. An object of the present invention is to provide a novel LCP extruded film having high metal foil peel strength, and an insulating material for a circuit substrate and a metal foil-clad laminate each using the LCP extruded film, as well as a novel method for manufacturing an LCP extruded film having high metal foil peel strength.

Solution to Problem

The present inventors have intensively studied to solve the above problems, and as a result, have newly produced an LCP extruded film having a small degradation of wettability on a film surface over time, and furthermore have found that the LCP extruded film has high metal foil peel strength, thereby completing the present invention.

That is, the present invention provides the various specific aspects shown below.

(1) An LCP extruded film having a film surface S1 and comprising a thermoplastic liquid crystal polymer, wherein a contact angle $\sigma_1$ of the film surface S1 of the LCP extruded film with water after one day from constant temperature and humidity treatment at 23°C and 50% RH is 60° or more and 80° or less, a contact angle $\sigma_7$ of the film surface S1 of the LCP extruded film with water after 7 days from constant temperature and humidity treatment at 23°C and 50% RH is 60° or more and 80° or less, and a rate of decrease (($\sigma_7$ - $\sigma_1$)/$\sigma_1$) of the contact angle $\sigma_7$ relative to the contact angle $\sigma_1$ is 10.0% or less.

(2) The LCP extruded film according to (1), wherein coefficients of linear thermal expansion in a MD direction and a TD direction of the LCP extruded film are each within a range of -30 to 55 ppm/K.

(3) The LCP extruded film according to (1) or (2), wherein the film is an intermediate layer obtained by removing both outer layers from a laminated extruded film having the outer layer, the intermediate layer, and the outer layer.

(4) The LCP extruded film according to any one of (1) to (3), wherein the film surface S1 is subjected to no physical surface treatment.

(5) The LCP extruded film according to any one of (1) to (4), wherein the film has a thickness of 15 $\mu$m or more and 300 $\mu$m or less, and a hardness H1 at a point of a depth of 1 $\mu$m located at a position of 1 $\mu$m from the film surface S1 in a thickness direction and a hardness H2 at a thickness center point, as measured by subjecting a film cross section in parallel with a MD direction to a nanoindentation method, satisfy -10.0 $\leq$ 100 $\times$ (H2 - H1)/H1 $\leq$ 0.0, and coefficients of linear thermal expansion in a MD direction and a TD direction of the LCP extruded film at 23 to 200°C as measured by a TMA method according to JIS K7197 are each within a range of -30 to 55 ppm/K.

(6) The LCP extruded film according to any one of (1) to (5), wherein the coefficient of linear thermal expansion in the TD direction of the LCP extruded film is 0 to 55 ppm/K.

(7) The LCP extruded film according to any one of (1) to (6), wherein the film surface S1 does not have any skin layer that is peelable by a tape in an adhesiveness test by a cross-cutting method according to JIS K5600-5-6.

(8) The LCP extruded film according to any one of (5) to (7), wherein the hardness H2 at the thickness center point is 0.240 (GPa) or more.

(9) The LCP extruded film according to any one of (5) to (8), wherein the hardness H1 at the point of a depth of 1 $\mu$m is 0.250 (GPa) or more.

(10) The LCP extruded film according to any one of (1) to (9), further containing an inorganic filler.

(11) The LCP extruded film according to any one of (1) to (10), wherein the LCP extruded film is a T-die extruded film.

(12) An insulating material for a circuit substrate, comprising a laminate having at least the LCP extruded film according to any one of (1) to (11) and a woven fabric provided on at least one surface of the LCP extruded film.

(13) A metal foil-clad laminate comprising the LCP extruded film according to any one of (1) to (11) and metal foil provided on one surface and/or both surfaces of the LCP extruded film.

(14) A metal foil-clad laminate comprising a laminate having at least the LCP extruded film according to any one of (1) to (11) and a woven fabric, and metal foil provided on one surface and/or both surfaces of the laminate.

(15) A method for manufacturing an LCP extruded film, comprising at least a step of co-extruding a resin composition for a first outer layer comprising one or more thermoplastic resins selected from the group consisting of a (meth)acrylic resin, a polyamide resin, polybutylene terephthalate, polyethylene terephthalate, polycarbonate, polyether ether ketone, and polyphenyl sulfide, a resin composition for an intermediate layer comprising a thermoplastic liquid crystal polymer, and a resin composition for a second outer layer comprising one or more thermoplastic resins selected from the group consisting of a (meth)acrylic resin, a polyamide resin, polybutylene terephthalate, polyethylene terephthalate, polycarbonate, polyether ether ketone, and polyphenyl sulfide, to obtain a co-extruded film having a laminated structure in which a first outer layer, an intermediate layer, and a second outer layer are arranged at the listed order, and a step of removing the first outer layer and the second outer layer from the co-extruded film to obtain the intermediate layer comprising the thermoplastic liquid crystal polymer, wherein, in the step of obtaining the intermediate layer, an LCP extruded film having a film surface S1 is obtained, in which a contact angle $\sigma_1$ of the film surface S1 of the LCP extruded film with water after one day from constant temperature and humidity treatment at 23°C and 50% RH is 60° or more and 80° or less, a contact angle $\sigma_7$ of the film surface S1 of the LCP extruded film with water after 7 days from constant temperature and humidity treatment at 23°C and 50% RH is 60° or more and 80° or less, and a rate of decrease $((\sigma_7 - \sigma_1)/\sigma_1)$ of the contact angle $\sigma_7$ relative to the contact angle $\sigma_1$ is 10.0% or less.

Advantageous Effects of Invention

One aspect of the present invention can realize novel LCP extruded film having high metal foil peel strength, and insulating material for a circuit substrate and metal foil-clad laminate each using the LCP extruded film, as well as a novel method for manufacturing an LCP extruded film having high metal foil peel strength. One aspect of the present invention can realize novel LCP extruded film, insulating material for a circuit substrate, and metal foil-clad laminate, which are reduced in anisotropy of the dimensional rate of change as compared with conventional one and in which the dimensional rates of change, by themselves, in a MD direction and a TD direction are small. Accordingly, various aspects of the present invention can realize a highly reliable product adaptable to recent ultrafine processing.

Brief Description of Drawings

[Figure 1] Figure 1 is a schematic perspective view of an LCP extruded film of one embodiment.
[Figure 2] Figure 2 illustrates a calculation method in hardness measurement according to a nanoindentation method.
[Figure 3] Figure 3 is a schematic cross-sectional view of an LCP extruded film of one embodiment.
[Figure 4] Figure 4 is a conceptual diagram of a calculation principle of the degree of alignment based on the alignment peak area ratio.
[Figure 5] Figure 5 illustrates a co-extrusion method of an LCP extruded film of one embodiment.
[Figure 6] Figure 6 illustrates a co-extrusion method of an LCP extruded film of one embodiment.
[Figure 7] Figure 7 illustrates a co-extrusion method of an LCP extruded film of one embodiment.
[Figure 8] Figure 8 is a schematic cross-sectional view of an insulating material for a circuit substrate, of one embodiment.
[Figure 9] Figure 9 is a schematic cross-sectional view of a metal foil-clad laminate of one embodiment.
[Figure 10] Figure 10 is a schematic cross-sectional view of a metal foil-clad laminate of one embodiment.

Description of Embodiments

Hereinafter, the embodiments of the present invention will be described in detail with reference to the drawings. Unless otherwise indicated, the positional relationship, such as top, bottom, left, and right is based on the positional relationship shown in the drawings. Also, the dimensional ratios of the drawings are not limited to those illustrated in the drawings. It should be noted that the following embodiments are merely examples for explaining the present invention, and the present invention is not limited thereto. That is, the present invention can be appropriately modified and implemented within a range not departing from the gist of the present invention. As used herein, for example, the description of the numerical value range "1 to 100" includes both the lower limit value "1" and the upper limit value "100". Also, the same applies to the description of other numerical value ranges.

(LCP extruded film)

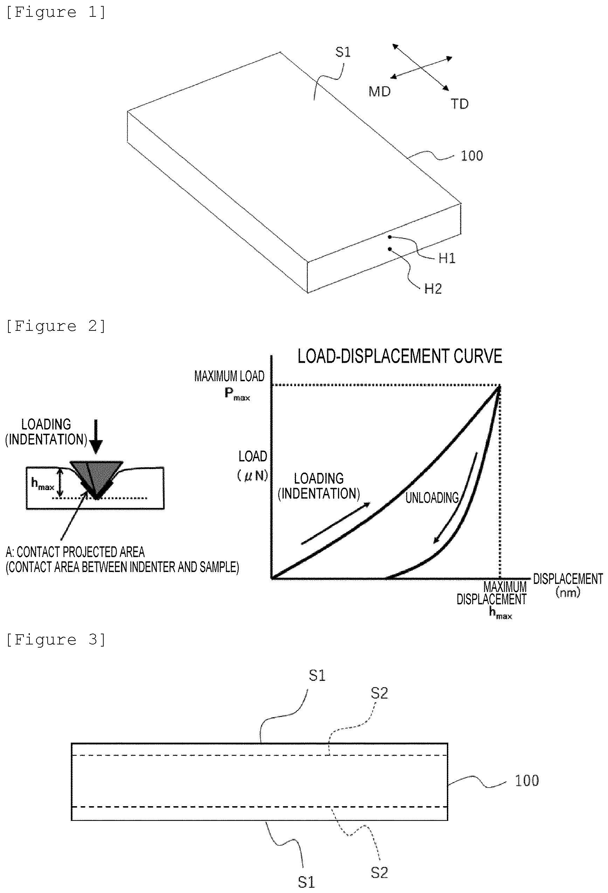

Figure 1 is a schematic cross-sectional view of a main portion of an LCP extruded film 100 of the present embodiment. The LCP extruded film 100 having a film surface S1, of the present embodiment, is obtained by extruding a thermoplastic liquid crystal polymer into a film, in which the contact angle $\sigma_1$ of the film surface S1 of the LCP extruded film with water after one day from constant temperature and humidity treatment at 23°C and 50% RH is 60° or more and 80° or less, the contact angle $\sigma_7$ of the film surface S1 of the LCP extruded film with water after 7 days from constant temperature and humidity treatment at 23°C and 50% RH is 60° or more and 80° or less, and the rate of decrease $((\sigma_7 - \sigma_1)/\sigma_1)$ of the contact angle $\sigma_7$ relative to the contact angle $\sigma_1$ is 10.0% or less.

The LCP extruded film 100 here used is preferably an extruded film such as a T-die extruded film. The LCP extruded film 100 here used is also preferably a thermoplastic liquid crystal polymer layer which is an intermediate layer (core layer) of a three layer co-extruded film having a laminated structure in which a thermoplastic resin layer, a thermoplastic liquid crystal polymer layer, and a thermoplastic resin layer are at least arranged in the listed order. In this case, the thermoplastic resin layers as both outer layers of the three layer co-extruded film can be removed to thereby allow the resultant to be used as a thermoplastic liquid crystal polymer film (LCP extruded film 100) of a single layer. An extruded film of a thermoplastic liquid crystal polymer can be produced which is low in cost and homogeneous as compared with woven fabrics and non-woven fabrics made of thermoplastic liquid crystal polymer fibers.

As the thermoplastic liquid crystal polymer contained in the LCP extruded film 100, those known in the art may be used, and the type thereof is not particularly limited. A liquid crystal polymer is a polymer that forms an optically anisotropic molten phase, and representative examples thereof include a thermotropic liquid crystal compound. The properties of the anisotropic molten phase can be confirmed by a known method such as a polarization test method using crossed polarizers. More specifically, the anisotropic molten phase can be confirmed by observing a sample placed on a Leitz hot stage with a Leitz polarization microscope under a nitrogen atmosphere at 40-fold magnification.

Specific examples of the thermoplastic liquid crystal polymer include those obtained by polycondensation of monomers such as aromatic or aliphatic dihydroxy compounds, aromatic or aliphatic dicarboxylic acids, aromatic hydroxycarboxylic acids, aromatic diamines, aromatic hydroxyamines, and aromatic aminocarboxylic acids, but are not particularly limited thereto. The thermoplastic liquid crystal polymer is preferably a copolymer. Specific examples include aromatic polyamide resins obtained by polycondensation of monomers such as aromatic hydroxycarboxylic acids, aromatic diamines, and aromatic hydroxyamines; and (wholly) aromatic polyester resins obtained by polycondensation of monomers such as aromatic diols, aromatic carboxylic acids, and aromatic hydroxycarboxylic acids; but are not particularly limited thereto. The thermoplastic liquid crystal polymer can be used singly or in any combination of two or more thereof at any ratio.

Thermoplastic liquid crystal polymers are typically categorized to Type I, Type II, Type III, and the like from the viewpoint of thermal distortion temperature (TDUL). Any type of thermoplastic liquid crystal polymers can be suitably used in the LCP extruded film 100 of the present embodiment, and may be appropriately selected and used depending on the intended application. For example, a Type I thermoplastic liquid crystal polymer having a TDUL of about 250 to 350°C and high heat resistance, or a Type II thermoplastic liquid crystal polymer having a TDUL of about 240 to 250°C and relatively high heat resistance is suitably used in an electronic circuit substrate application where application to a lead-free solder at about 230 to 260°C is demanded.

Among these, a (wholly) aromatic polyester resin that exhibits thermotropic liquid crystalline properties and has a melting point of 250°C or more, preferably a melting point of 280°C to 380°C is preferably used. As such a (wholly) aromatic polyester resin, (wholly) aromatic polyester resins that are synthesized from monomers such as aromatic diols, aromatic carboxylic acids, and hydroxycarboxylic acids and that exhibit liquid crystallinity during melting are known. Representative examples thereof include, but are not particularly limited to, a polycondensate of ethylene terephthalate and para-hydroxybenzoic acid, a polycondensate of phenolic and phthalic acids and para-hydroxybenzoic acid, and a polycondensate of 2,6-hydroxynaphthoic acid and para-hydroxybenzoic acid. The (wholly) aromatic polyester resin can be used singly or in any combination of two or more thereof at any ratio. A wholly aromatic polyester resin having a relatively high melting point or a high thermal distortion temperature and high heat resistance or an aromatic polyester resin having a relatively low melting point or a low thermal distortion temperature and excellent fabricability can be used depending on the desired performance.

In preferable one aspect, a (wholly) aromatic polyester resin at least having 6-hydroxy-2-naphthoic acid and a derivative thereof (hereinafter, sometimes simply referred to as "monomer component A".) which is a basic structure, and having one or more monomer component(s) (hereinafter, sometimes simply referred to as "monomer component B".) selected from the group consisting of para-hydroxybenzoic acid, terephthalic acid, isophthalic acid, 6-naphthalenedicarboxylic acid, 4,4'-biphenol, bisphenol A, hydroquinone, 4,4-dihydroxybiphenol, ethylene terephthalate and derivatives thereof is exemplified. The (wholly) aromatic polyester resin forms an anisotropic molten phase in which linear chains of molecules are regularly aligned in a molten state, typically exhibits thermotropic liquid crystalline properties, and has excellent basic performance such as mechanical characteristics, electrical characteristics, high frequency characteristics, heat resistance, and hygroscopicity.

The (wholly) aromatic polyester resin of preferable one aspect, described above, may employ any constitution as long as it has the monomer component A and the monomer component B as essential units. For example, it may have two or more monomer components A, or three or more monomer components A. The (wholly) aromatic polyester resin of preferable one aspect, described above, may contain other monomer component (hereinafter, sometimes simply referred to as "monomer component C".) other than the monomer component A and the monomer component B. That is, the (wholly) aromatic polyester resin of preferable one aspect, described above, may be a binary or higher polycondensate consisting of only the monomer component A and the monomer component B, or may be a ternary or higher polycondensate consisting of the monomer component A, the monomer component B, and monomer component C.

Other monomer components are other than the monomer component A and the monomer component B described above, and specific examples thereof include aromatic or aliphatic dihydroxy compounds and derivatives thereof; aromatic or aliphatic dicarboxylic acid and derivatives thereof; aromatic hydroxycarboxylic acid and derivatives thereof; aromatic diamine, aromatic hydroxyamine, or aromatic aminocarboxylic acid and derivatives thereof, but are not particularly limited thereto. Such other monomer component can be used singly or in any combination of two or more thereof at any ratio.

As used herein, the "derivatives" means those which have a modifying group such as a halogen atom (e.g., a fluorine atom, a chlorine atom, a bromine atom, and an iodine atom), an alkyl group having 1 to 5 carbon atoms (e.g., a methyl group, an ethyl group, an n-propyl group, an isopropyl group, an n-butyl group, an isobutyl group, an s-butyl group, and a t-butyl group), an aryl group such as a phenyl group, a hydroxyl group, an alkoxy group having 1 to 5 carbon atoms (e.g., a methoxy group and an ethoxy group), a carbonyl group, -O-, -S-, and $-CH_2-$ introduced in a part of the monomer components described above (hereinafter, also referred to as "monomer component having a substituent"). Here, the "derivatives" may be acylated products, ester derivatives, or ester forming monomers such as acid halides, of the monomer components A and B, which may have a modifying group described above.

Examples of particularly preferable one aspect include a binary polycondensate of para-hydroxybenzoic acid and derivatives thereof, and 6-hydroxy-2-naphthoic acid and derivatives thereof; a ternary or higher polycondensate of para-hydroxybenzoic acid and derivatives thereof, 6-hydroxy-2-naphthoic acid and derivatives thereof, and the monomer component C; a ternary or higher polycondensate of para-hydroxybenzoic acid and derivatives thereof, 6-hydroxy-2-naphthoic acid and derivatives thereof, and at least one selected from the group consisting of terephthalic acid, isophthalic acid, 6-naphthalenedicarboxylic acid, 4,4'-biphenol, bisphenol A, hydroquinone, 4,4-dihydroxybiphenol, ethylene terephthalate, and derivatives thereof; a quaternary or higher polycondensate of para-hydroxybenzoic acid and derivatives thereof, 6-hydroxy-2-naphthoic acid and derivatives thereof, at least one selected from the group consisting of terephthalic acid, isophthalic acid, 6-naphthalenedicarboxylic acid, 4,4'-biphenol, bisphenol A, hydroquinone, 4,4-dihydroxybiphenol, ethylene terephthalate, and derivatives thereof, and one or more monomer components C. These can be obtained as having a relatively low melting point as compared with, for example, a homopolymer of para-hydroxybenzoic acid, and thus, the thermoplastic liquid crystal polymer using these polymers has excellent fabricability in the thermocompression bonding to an adherend.

From the viewpoint of reducing the melting point of the (wholly) aromatic polyester resin, increasing the fabricability of the LCP extruded film 100 in the thermocompression bonding to an adherend, obtaining high peel strength when the LCP extruded film 100 is thermocompression bonded to a metal foil, or the like, the content in terms of molar ratio of the monomer component A to the (wholly) aromatic polyester resin is preferably 10 mol% or more and 90 mol% or less, more preferably 30 mol% or more and 85 mol% or less, and further preferably 50 mol% or more and 80 mol% or less. Similarly, the content in terms of molar ratio of the monomer component B to the (wholly) aromatic polyester resin is preferably 10 mol% or more and 90 mol% or less, more preferably 15 mol% or more and 70 mol% or less, and further preferably 20 mol% or more and 50 mol% or less. The content of the monomer component C that may be contained in the (wholly) aromatic polyester resin is preferably 10 mol% or less, more preferably 8 mol% or less, further preferably 5 mol% or less, and particularly preferably 3 mol% or less in terms of molar ratio.

A known method may be applied to the synthetic method of the (wholly) aromatic polyester resin without particular limitation. A known polycondensation method to form ester bonds by the monomer components described above, such as melt polymerization, a melt acidolysis method, and a slurry polymerization method can be applied. When these polymerization methods are applied, an acylation or acetylation step may be performed in accordance with a conventional method.

The LCP extruded film 100 may further contain an inorganic filler. The LCP extruded film 100, which contains an inorganic filler, thus can be realized to have a reduced coefficient of linear thermal expansion, and specifically, the LCP extruded film 100, which is reduced in anisotropy of the coefficients of linear thermal expansion in the MD direction, the TD direction and the ZD direction (Z-axis Direction; film thickness direction), is easily obtained. Such an LCP extruded film 100 is particularly useful for, for example, rigid substrate applications in which multilayer laminates are required.

As the inorganic filler, those known in the art may be used, and the type thereof is not particularly limited. Examples include kaolin, fired kaolin, fired clay, unfired clay, silica (e.g., natural silica, fused silica, amorphous silica, hollow silica, wet silica, synthetic silica, and aerosil), aluminum compounds (e.g., boehmite, aluminum hydroxide, alumina, hydrotalcite, aluminum borate, and aluminum nitride), magnesium compounds (e.g., magnesium aluminometasilicate, magnesium carbonate, magnesium oxide, and magnesium hydroxide), calcium compounds (e.g., calcium carbonate, calcium hydroxide, calcium sulfate, calcium sulfite, and calcium borate), molybdenum compounds (e.g., molybdenum oxide and zinc molybdate), talc (e.g., natural talc and fired talc), mica, titanium oxide, zinc oxide, zirconium oxide, barium sulfate, zinc borate, barium metaborate, sodium borate, boron nitride, aggregated boron nitride, silicon nitride, carbon nitride, strontium titanate, barium titanate, and stannate such as zinc stannate, but are not particularly limited thereto. The inorganic filler can be used singly or in combinations of two or more thereof. Among these, silica is preferable from the viewpoint of dielectric characteristics and the like.

The inorganic filler here used may be one subjected to surface treatment known in the art. The surface treatment can allow for enhancements in moisture resistance, adhesion strength, dispersibility, and the like. Examples of the surface treatment agent include a silane coupling agent, a titanate coupling agent, sulfonate, carboxylate, and phosphate, but are not particularly limited thereto.

The median diameter (d50) of the inorganic filler can be appropriately set depending on the desired performance, and is not particularly limited. The d50 of the inorganic filler is preferably 0.01 $\mu$m or more and 50 $\mu$m or less, more preferably 0.03 $\mu$m or more and 50 $\mu$m or less, and further preferably 0.1 $\mu$m or more and 50 $\mu$m or less from the viewpoint of kneading ability and handleability in preparation, and the effect of reducing the coefficients of linear thermal expansion. As used herein, the median diameter (d50) of the inorganic filler refers to a value measured on a volume basis with a laser diffraction/scattering particle size distribution measurement apparatus (LA-500 manufactured by Horiba Ltd.) by a laser diffraction/scattering method.

The content of the inorganic filler can be appropriately set depending on the desired performance in consideration of the blending balance with other essential component and optional component, and is not particularly limited. The content of the inorganic filler in terms of solid content based on the total amount of the LCP extruded film 100 is preferably 1% by mass or more and 45% by mass or less in total, more preferably 3% by mass or more and 40% by mass or less in total, and further preferably 5% by mass or more and 35% by mass or less in total, from the viewpoint of kneading ability and handleability in preparation, and the effect of reducing the coefficients of linear thermal expansion.

The LCP extruded film 100 may contain a resin component other than the thermoplastic liquid crystal polymer described above (hereinafter, sometimes simply referred to as "other resin component".), for example, a thermosetting resin and/or a thermoplastic resin, within a range not excessively impairing the effects of the present invention. The LCP extruded film 100 may each contain additives known in the art, for example, release improving agents such as higher fatty acids having 10 to 25 carbon atoms, higher fatty acid esters, higher fatty acid amide, higher fatty acid metal salts, polysiloxane, and fluorine resins; colorants such as dyes and pigments; organic fillers; antioxidants; thermal stabilizers; light stabilizers; ultraviolet absorbers; flame retardants; antistatic agents; surfactants; anticorrosives; defoaming agents; and fluorescent agents, within a range not excessively impairing the effects of the present invention. These additives can be used each one alone or in combination of two or more. These additives can be contained in a molten resin composition prepared during formation of the LCP extruded film 100. The contents of such resin component and additive are not particularly limited, but are preferably each 0.01 to 10% by mass, more preferably each 0.1 to 7% by mass, further preferably each 0.5 to 5% by mass based on a total amount of the LCP extruded film 100, from the viewpoint of fabricability, thermal stability, and the like.

The thickness of the LCP extruded film 100 can be appropriately set depending on the desired performance and is not particularly limited. Considering the handleability and the productivity during extrusion and the like, the thickness is preferably 15 $\mu$m or more and 300 $\mu$m or less, more preferably 18 $\mu$m or more and 250 $\mu$m or less, and further preferably 20 $\mu$m or more and 200 $\mu$m or less.

The contact angle $\sigma_1$ of the film surface S1 of the LCP extruded film 100 with water after one day from constant temperature and humidity treatment at 23°C and 50% RH is 60° or more and 80° or less, preferably 60° or more and 78° or less, and further preferably 60° or more and 75° or less. The contact angle $\sigma_7$ of the film surface S1 of the LCP extruded film 100 with water after 7 days from constant temperature and humidity treatment at 23°C and 50% RH is 60° or more and 80° or less, preferably 60° or more and 78° or less, and further preferably 60° or more and 75° or less. The rate of decrease $((\sigma_7 - \sigma_1)/\sigma_1)$ of the contact angle $\sigma_7$ relative to the contact angle $\sigma_1$ is 10.0% or less, preferably 9.0% or less, and further preferably 8.5% or less. The lower limit value of the rate of decrease is, of course, 0%. The LCP extruded film 100 of the present embodiment has relatively small contact angle $\sigma_1$ and contact angle $\sigma_7$ with water, as described above, and has high adhesiveness to metal foil, and thus higher metal foil peel strength than conventional one is obtained. The LCP extruded film 100 of the present embodiment has small degradation (rate of decrease $((\sigma_7 - \sigma_1)/\sigma_1)$) of the contact angle with water over time as compared with one subjected to physical surface treatment such as oxygen plasma treatment, ozone treatment, or corona discharge treatment, and thus can be subjected to a step of compression bonding with metal foil both immediately after manufacturing and after storage for a long period.

As used herein, the contact angle $\sigma_1$ and the contact angle $\sigma_7$ of the film surface S1 with water each mean a value obtained by using an automatic contact angle meter (DMC-MC3, manufactured by Kyowa Interface Science Co., Ltd.), dropping distilled water (amount of liquid 4 $\mu$L) as a measurement liquid, onto the film surface S1 of the LCP extruded film 100, under the environment at 23°C and 50% RH, and calculating the contact angle after 3 seconds from the dropping, based on a tangent method.

As described above, an LCP extruded film as a conventional technique has been one having a film surface S1 in which a thermoplastic liquid crystal polymer is extremely molecularly oriented, for example, peeling of a skin layer and/or peeling of a fibrillated fiber occur(s). It has been presumed that shear stress is applied from an apparatus side surface in extrusion to result in high alignment of the thermoplastic liquid crystal polymer in the surface of an extruded product. Although it has been confirmed that such extreme molecular orientation of the thermoplastic liquid crystal polymer in the film surface S1 is relaxed due to an improvement as in Patent Literature 1, it has been simultaneously found by findings of the present inventors that one capable of withstanding the desired performance of an insulating material of a circuit substrate cannot be realized by only control of the molecular orientation of the thermoplastic liquid crystal polymer in the film surface S1. The technique of Patent Literature 1 has caused a still large difference between the dimensional rates of change in the TD direction and the MD direction after etching, and has been incapable of meeting a demand of application to recent ultrafine processing. In other words, it is necessary for realization of an LCP extruded film reduced in anisotropy of the dimensional rate of change to not only control the molecular orientation of the thermoplastic liquid crystal polymer in the film surface S1, but also control the molecular orientation of the thermoplastic liquid crystal polymer, occurring in a film interior, and reduce internal strain and the like.

In preferable one aspect of the LCP extruded film 100 of the present embodiment, the molecular orientation of the thermoplastic liquid crystal polymer, internal strain, and the like are relaxed in not only the film surface S1, but also the film interior, unlike the conventional technique, and thus anisotropy of the dimensional rate of change is especially reduced, as compared with conventional one. In other words, in preferable one aspect of the LCP extruded film 100 of the present embodiment, the hardness H1 at a point of a depth of 1 $\mu$m located at a position of 1 $\mu$m from the film surface S1 in a thickness direction and the hardness H2 at the thickness center point, as measured by subjecting a film cross section in parallel with the MD direction to a nanoindentation method, satisfy -10.0 $\leq$ 100 $\times$ (H2 - H1)/H1 $\leq$ 0.0, and the coefficients of linear thermal expansion in the MD direction and the TD direction at 23 to 200°C as measured by a TMA method according to JIS K7197 are each within a range of -30 to 55 ppm/K.

In preferable one aspect of the LCP extruded film 100 of the present embodiment, from the viewpoint of relaxing the molecular orientation of the thermoplastic liquid crystal polymer, internal strain, and the like in not only the film surface S1, but also the film interior, and reducing the anisotropy of the dimensional rate of change intended, the hardness H1 at a point of a depth of 1 $\mu$m located at a position of 1 $\mu$m from the film surface S1 in a thickness direction and the hardness H2 at the thickness center point, as measured by subjecting a film cross section in parallel with the MD direction to a nanoindentation method, are adjusted so as to satisfy the following relationship:

preferably -10.0 $\leq$ 100 $\times$ (H2 - H1)/H1 $\leq$ 0.0.
more preferably - 7.5 $\leq$ 100 $\times$ (H2 - H1)/H1 $\leq$ 0.0.
further preferably - 5.0 $\leq$ 100 $\times$ (H2 - H1)/H1 $\leq$ 0.0.

The relationship represented by the above expressions, namely, the relationship between the hardness H1 at a point of a depth of 1 $\mu$m and the hardness H2 at the thickness center point represents the alignment of the thermoplastic liquid crystal polymer in the film, and it is meant that, as the absolute value is lower, the alignments in the MD direction and the TD direction are more isotropic.

The hardness H1 at a point of a depth of 1 $\mu$m located at a position of 1 $\mu$m from the film surface S1 in the thickness direction (a position of 1 $\mu$m from one film surface S1 in the thickness direction in planar view of the film cross section), in the film cross section in parallel with the MD direction, is an index representing the molecular orientation of the thermoplastic liquid crystal polymer, internal strain, and the like in the vicinity of the film surface S1 of the LCP extruded film 100. The hardness H1 at a point of a depth of 1 $\mu$m tends to be higher as the alignment of the thermoplastic liquid crystal polymer is lower, and the hardness tends to be lower as the alignment of the thermoplastic liquid crystal polymer is higher. The hardness H1 at a point of a depth of 1 $\mu$m is preferably 0.250 GPa or more, and more preferably 0.255 GPa or more. On the other hand, the hardness H2 at the thickness center point (a position at the equal interval from one film surface S1 and other film surface in planar view of the film cross section) in the film cross section in parallel with the MD direction is an index representing the molecular orientation of the thermoplastic liquid crystal polymer, internal strain, and the like in the film interior of the LCP extruded film 100. The hardness H2 at the thickness center point tends to be higher as the alignment of the thermoplastic liquid crystal polymer is lower, and the hardness tends to be lower as the alignment of the thermoplastic liquid crystal polymer is higher. The hardness H2 at the thickness center point is preferably 0.240 GPa or more, and more preferably 0.245 GPa or more. The method for producing the film cross section in parallel with the MD direction of the LCP extruded film 100 is not particularly limited, and a film smooth cross section in parallel with the MD direction is produced by ion beam processing of the LCP extruded film 100 under freezing conditions, from the viewpoint of retention of objectivity of the measurement data.

As used herein, the hardness measurement according to a nanoindentation method is performed by subjecting the film cross section in parallel with the MD direction of the LCP extruded film 100 to measurement of the hardness H1 at a point of 1 $\mu$m from the film surface S1 and the hardness H2 at the thickness center point with a diamond Berkovich indenter under a condition of an indentation depth hmax of 0.05 $\mu$m. The hardness H1 and the hardness H2 are calculated from the following expression based on the maximum load Pmax and the contact projected area A (area in which the indenter and the film cross section are in contact with each other), as illustrated in Figure 2.

```
Hardness (GPa) = Pmax/A
```

In preferable one aspect of the LCP extruded film 100 of the present embodiment, not only the molecular orientation of the thermoplastic liquid crystal polymer, represented by the above degrees of alignment, but also the molecular orientation of the thermoplastic liquid crystal polymer, represented by the coefficients of linear thermal expansion in the MD direction and the TD direction is sufficiently reduced. As described above, the LCP extruded film as the conventional technique described in Patent Literature 1 has been slightly relaxed in molecular orientation of the thermoplastic liquid crystal polymer due to protection by the thermoplastic resin layers of both outer layers in three layer co-extrusion to result in relaxation of anisotropies of the strengths in the MD direction and TD direction of the resulting thermoplastic liquid crystal polymer film. However, in fact, the LCP extruded film described in Patent Literature 1, while has stably achieved a coefficient of linear thermal expansion in the MD direction, of about -20 ppm/K, has exhibited a coefficient of linear thermal expansion in the TD direction, of more than 55 ppm, sometimes has reached about 100 ppm/K. As clear from this, it is easily understood that the molecular orientation of the thermoplastic liquid crystal polymer still largely remains or the internal strain and the like largely remain in the entire film of the LCP extruded film as the conventional technique described in Patent Literature 1. Accordingly, the molecular orientation of the thermoplastic liquid crystal polymer, internal strain, and the like of the entire film of the LCP extruded film 100 are needed to be controlled by a combination of the hardnesses by the above nanoindentation method and the coefficients of linear thermal expansion.

In preferable one aspect of the LCP extruded film 100 of the present embodiment, the coefficients of linear thermal expansion in the MD direction and the TD direction (CTE, $\alpha2$, 23 to 200°C) are each within a range from -30 to 55 ppm/K. The LCP extruded film 100, in which the coefficients of linear thermal expansion are each within such a range, is sufficiently reduced in internal strain and the like, and can be an LCP extruded film which is small in anisotropy of the dimensional rate of change and sufficiently small in absolute value of the dimensional rate of change as compared with those in which the coefficients are not each within such a range. The coefficient of linear thermal expansion (CTE, $\alpha2$, 23 to 200°C) in the MD direction of the LCP extruded film 100 of the present embodiment is preferably within a range from -30 to 40 ppm/K, more preferably within a range from -25 to 30 ppm/K, and further preferably within a range from -20 to 20 ppm/K from the viewpoint of increasing adhesiveness to metal foil, or the like. In preferable one aspect of the LCP extruded film 100 of the present embodiment, the coefficient of linear thermal expansion (CTE, $\alpha2$, 23 to 200°C) in the TD direction is preferably within a range from 0 to 55 ppm/K, more preferably within a range from 0 to 50 ppm/K, and further preferably within a range from 0 to 45 ppm/K, from the viewpoint of increasing adhesiveness to metal foil, or the like.

The coefficient of linear thermal expansion is herein measured by a TMA method according to JIS K7197 and the average coefficient of linear thermal expansion, as used herein, refers to an average value of the coefficient of linear thermal expansion at 23 to 200°C as measured by the relevant method. To observe a value from which the thermal history has been eliminated, the coefficient of linear thermal expansion, here measured, refers to a value obtained when the LCP extruded film 100 is heated at a temperature rising rate of 5°C/min (1st heating), cooled to the measurement environment temperature (23°C) (1st cooling), and then heated for the second time at a temperature rising rate of 5°C/min (2nd heating). Other detailed measurement conditions are in accordance with the conditions described in the Examples below.

In preferable one aspect of the LCP extruded film 100 of the present embodiment, from the viewpoint of relaxing the molecular orientation of the thermoplastic liquid crystal polymer, internal strain, and the like in not only the film surface S1, but also the film interior, and reducing the anisotropy of the dimensional rate of change intended, the degree of alignment $\alpha1$ of the film surface S1 exposed, and the degree of alignment $\alpha2$ of the film surface S2 exposed by etching treatment in a thickness direction of the film surface S1 and located at a depth of 5 $\mu$m from the film surface S1 desirably satisfy the following relationship:

preferably

$$-4.0 \leq [(\alpha2 - \alpha1)/\alpha1] \times 100 \leq 0.0.$$

more preferably

$$-3.0 \leq [(\alpha2 - \alpha1)/\alpha1] \times 100 \leq 0.0.$$

further preferably

$$-2.0 \leq [(\alpha2 - \alpha1)/\alpha1] \times 100 \leq$$

0.0.

As illustrated in Figure 3, the film surface S1 is an outermost surface of the LCP extruded film 100 of the present embodiment and is an exposed surface outward. The degree of alignment (degree of alignment $\alpha$1) of the film surface S1 is preferably 39.0% or less, more preferably 38.5% or less, and further preferably 38.0% or less. On the other hand, the film surface S2 is a surface newly exposed by etching treatment in the thickness direction of the film surface S1 of the LCP extruded film 100 of the present embodiment, and is indicated as a virtual surface located at a depth of 5 $\mu$m from the film surface S1, by a dashed line in Figure 3. The degree of alignment (degree of alignment $\alpha$2) of the film surface S2 is preferably 37.7% or less, more preferably 37.5% or less, and further preferably 37.3% or less. The depth at which the film surface S2 is located is not needed to be exactly 5 $\mu$m from the film surface S1, in consideration of the dissolution error or the like during etching, and may be 5.0 $\mu$m or more from the film surface S1. The etching treatment conditions for production of the film surface S2 are not particularly limited, and follow conditions described in Examples below, from the viewpoint of retention of objectivity of the measurement data.

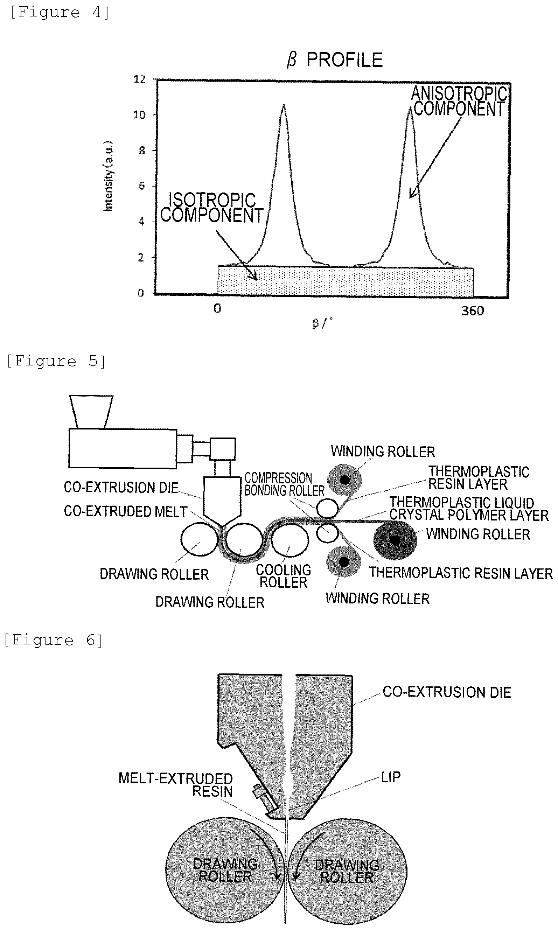

As used herein, the respective degrees of alignment $\alpha$1 and $\alpha$2 (%) of the film surfaces S1 and S2 of the LCP extruded film 100 refer to values each determined by X-ray diffraction measurement with an X-ray diffraction apparatus according to a transmission method and then calculation from the following expression based on the alignment peak area ratio in the resulting diffraction intensity distribution curve. Typically, in the case of a measurement subject having a low degree of alignment (%), a low peak intensity and a broad diffraction peak are observed by the X-ray diffraction measurement, and thus a high measurement accuracy cannot be retained in a calculation method based on the half-value width of an alignment peak. Therefore, herein, the respective degrees of alignment $\alpha$1 and $\alpha$2 (%) of the film surfaces S1 and S2 are calculated by not the half-value widths of alignment peaks, but a calculation method based on the alignment peak area ratio. Specifically, the calculation method based on the alignment peak area ratio, as represented in Figure 4 and expression 1, includes measuring not only the peak intensity (alignment component) by 2$\theta$/$\theta$ scan, but also the intensity at 0° to 360° in a bearing angle direction by $\beta$ scan, to thereby obtain an intensity distribution (base intensity (isotropic component)) in the bearing angle direction, and calculating the proportion of the area of the alignment component, excluding the area of the isotropic component as the base, in the entire area (area of alignment component + area of isotropic component), as the degree of alignment (%).

$$\text{Degree of alignment [\%]} = \frac{\text{Area of peak portion (alignment component)}}{\text{Whole area (alignment component + isotropic component)}}$$

The dielectric characteristics of the LCP extruded film 100 of the present embodiment can be appropriately set depending on the desired performance, and are not particularly limited. From the viewpoint of obtaining higher dielectric characteristics, the relative dielectric constant $\varepsilon_r$ (36 GHz) is preferably 2.5 or more and 3.7 or less, more preferably 3.0 to 3.5. Similarly, the dielectric loss tangent tan$\delta$ (36 GHz) is preferably 0.0010 or more and 0.0050 or less, more preferably 0.0010 or more and 0.0045 or less. As used herein, the relative dielectric constant $\varepsilon_r$ and the dielectric loss tangent tan$\delta$ refer to respective values at 36 GHz as measured by a cavity resonator perturbation method according to JIS K6471. Other specific measurement conditions are in accordance with conditions described in the Examples below.

(Method for manufacturing LCP extruded film)

The LCP extruded film 100 of the present embodiment can be obtained by extruding a resin composition including the thermoplastic liquid crystal polymer described above and if necessary optional component(s) such as an inorganic filler and/or other resin component, in a predetermined thickness. The extrusion method here applied can be any of various known methods, and the type thereof is not particularly limited. For example, a T-die method or an inflation method; for example, a multi-manifold type co-extrusion method or a feed block type co-extrusion method; for example, a multilayer co-extrusion method such as a two layer co-extrusion method or a three layer co-extrusion method; can be arbitrarily combined and applied.

Especially, preferable one aspect provides, for example, a method for obtaining a predetermined LCP extruded film 100 by molding of the above resin composition into a film through a T-die according to an extrusion method with a T-die (hereinafter, sometimes simply referred to as "T-die extrusion method".) and then, if necessary, cooling treatment, compression bonding treatment, heating and pressurizing treatment, and/or the like, from the viewpoint of ease of control of the respective molecular orientations of the thermoplastic liquid crystal polymers in the film surface (film surface S1) and the film interior (film surface S2). Specifically, a co-extrusion method is preferable which involves preparing a resin composition A for a first outer layer comprising a thermoplastic resin, a resin composition B for an intermediate layer comprising a thermoplastic liquid crystal polymer, and a resin composition C for a second outer layer comprising a thermoplastic resin, respectively, and co-extruding them through a co-extrusion die of an extruder and thus extruding a co-extruded melt of a three layer configuration, to thereby form the LCP extruded film 100 as a thermoplastic liquid crystal polymer layer of an intermediate layer. Such co-extrusion leads to protection by the thermoplastic resin layers of both outer layers and thus relaxation of the molecular orientation of the thermoplastic liquid crystal polymer in the thermoplastic liquid crystal polymer layer as the intermediate layer.

Figure 5 to Figure 7 illustrate preferable one aspect of the method for manufacturing the LCP extruded film 100 of the present embodiment. Here, the above resin composition B comprising the thermoplastic liquid crystal polymer described above and if necessary optional component(s) such as an inorganic filler and/or other resin component is melt-extruded into a film through a T-die of an extruder. The resin compositions A and C each comprising a thermoplastic resin are co-extruded onto both surfaces of the above film-shaped melt-extruded product, and thus a co-extruded melt (three layer laminated film) having a predetermined thickness is produced which has a first outer layer (release layer) comprising a thermoplastic resin, an intermediate layer (LCP layer) comprising a thermoplastic liquid crystal polymer, and a second outer layer (release layer) comprising a thermoplastic resin. The co-extruded melt is drawn by a drawing roller, and sent to a cooling roller and a compression bonding roller. Thereafter, the first outer layer and the second outer layer are separated from the intermediate layer, and the thermoplastic resin layers as both outer layers, and the thermoplastic liquid crystal polymer layer (LCP extruded film 100) as the intermediate layer are each wound by a winding roller.

The resin composition B comprising the thermoplastic liquid crystal polymer may be prepared in accordance with a conventional method, and is not particularly limited. The components described above can be manufactured and processed by a known method such as kneading, melt-kneading, granulation, extrusion, and pressing or injection molding. When melt-kneading is performed, commonly used uniaxial or biaxial extruders or kneading apparatuses such as various kneaders can be used. When various components are supplied to these melt-kneading apparatuses, the liquid crystal polymer, other resin component, the inorganic filler, the additive, and the like may be dry blended in advance with a mixing apparatus such as a tumbler and a Henschel mixer. Upon melt-kneading, the cylinder set temperature of the kneading apparatus may be appropriately set without particular limitation, and is typically preferably within a range of the melting point of the liquid crystal polymer or more and 360°C or less, and more preferably the melting point of the liquid crystal polymer +10°C or more and 360°C or less.

The preparation of the resin compositions A and C each comprising the thermoplastic resin may also be performed in accordance with a conventional method, and is not particularly limited. The thermoplastic resin here used is preferably one or more polar resins selected from the group consisting of a (meth)acrylic resin such as PMMA, a polyamide resin, polybutylene terephthalate (PBT), polyethylene terephthalate (PET), polycarbonate (PC), polyether ether ketone (PEEK), and polyphenyl sulfide (PPS). Even either a polar resin such as polycarbonate or a non-polar resin such as polymethylpentene can effectively serve as a release layer, when formed into a co-extruded melt, and a preferable polar resin exemplified can be used to allow the above contact angle $\sigma_1$ and contact angle $\sigma_7$, and rate of decrease (($\sigma_7$ - $\sigma_1$)/$\sigma_1$) to be realized in a simple manner with good reproducibility. The thermoplastic resins in the resin compositions A and C may be each blended with other resin component and an optional component such as an inorganic filler which are optionally contained in the LCP extruded film 100. The resin composition A and the resin composition C may be the same or different in terms of the resin composition ratio, and may contain the same or different thermoplastic resins. The resin compositions A, C each comprising the thermoplastic resin can be manufactured and processed by a known method such as kneading, melt-kneading, granulation, extrusion, and pressing or injection molding. When melt-kneading is performed, uniaxial or biaxial extruders or kneading apparatuses such as various kneaders, commonly used, can be used. When various components are supplied to these melt-kneading apparatuses, the thermoplastic resin, other resin component, the inorganic filler, the additive, and the like may be dry blended by use of a mixing apparatus such as a tumbler and a Henschel mixer. Upon melt-kneading, the cylinder set temperature of the kneading apparatus may be appropriately set to a temperature equal to or less than the temperature not causing any degradation of the thermoplastic resin due to pyrolysis, is not particularly limited, and is typically preferably equal to or more than the melting point of the thermoplastic resin, more preferably the melting point of the thermoplastic resin +10°C or more. The contents of such other resin component and additive in the resin compositions A and C are not particularly limited, but are preferably each 0.01 to 10% by mass, more preferably each 0.1 to 7% by mass, and further preferably each 0.5 to 5% by mass based on a total amount of the LCP extruded film 100, from the viewpoint of fabricability, thermal stability, and the like.

The set conditions of the co-extrusion may be appropriately set depending on the types and compositions of the resin compositions to be used, the desired performance of the intended extruded film, and the like, and are not particularly limited. For example, the set temperature of the cylinder of the extruder may be appropriately set depending on the types and compositions of the resin compositions to be used, the desired performance of the intended extruded film, and the like, is not particularly limited, and is preferably 230 to 360°C, and more preferably 280 to 350°C.

For example, the die width (mm) of the T-die may also be appropriately set depending on the types and compositions of the resin compositions to be used, the desired performance of the intended extruded film, and the like, is not particularly limited, and is typically preferably 200 to 2000 mm, and more preferably 400 to 1500 mm.

For example, the lip opening (mm) of the T-die may also be appropriately set depending on the types and compositions of the resin compositions to be used, the desired performance of the intended extruded film, and the like, is not particularly limited, and is typically preferably 0.1 to 3.0 (mm), and more preferably 0.2 to 2.0 (mm) .

For example, the shear rate (sec$^{-1}$) on the lip wall of the T-die may also be appropriately set depending on the types and compositions of the resin compositions to be used, the desired performance of the intended extruded film, and the like, is not particularly limited, and is typically preferably 100 to 1500 (sec$^{-1}$), and more preferably 150 to 1000 (sec$^{-1}$).

The total amount of ejection (mm$^3$/sec) of the resin compositions through the T-die may also be appropriately set depending on the types and compositions of the resin compositions to be used, the desired performance of the intended extruded film, and the like, is not particularly limited, and is typically preferably 500 to 15000 (mm$^3$/sec), and more preferably 1500 to 10000 (mm$^3$/sec).

The melt viscosity (Pa·sec) of the thermoplastic liquid crystal polymer may also be appropriately set depending on the types and compositions of the resin compositions to be used, the desired performance of the intended extruded film, and the like, is not particularly limited, and is typically preferably 10 to 300 (Pa-sec), and more preferably 20 to 250 (Pa.sec). The melt viscosity (Pa·sec) of the thermoplastic liquid crystal polymer refers to a value measured with Capilograph 1D (manufactured by Toyo Seiki Seisaku-sho, Ltd.) according to JIS K7199, under conditions of a cylinder diameter of 10.00 mm, a cylinder size of 1.00 mm, and a barrel diameter of 9.55 mm and under the manufacturing conditions of the LCP extruded film 100 (die temperature, and shear rate of lip wall).

The drawing speed (mm/sec) of the co-extruded film may also be appropriately set depending on the types and compositions of the resin compositions to be used, the desired performance of the intended extruded film, and the like, is not particularly limited, and is typically preferably 15 to 1000 (mm/sec), and more preferably 20 to 500 (mm/sec).

The shear stress (kPa) during co-extrusion is desirably low from the viewpoint of reducing the molecular orientation in the MD direction of the thermoplastic liquid crystal polymer during co-extrusion. When the shear stress during co-extrusion is high, the thermoplastic liquid crystal polymer tends to be easily highly aligned in the MD direction and the internal strain tends to easily remain, and when the shear stress during co-extrusion is low, the molecular orientation of the thermoplastic liquid crystal polymer tends to be easily reduced in both the film surface S1 and the film interior and the internal strain tends to hardly remain. The shear stress (kPa) during co-extrusion is a value represented by the product of the shear rate (sec$^{-1}$) on the lip wall and the melt viscosity (Pa·sec) of the thermoplastic liquid crystal polymer, and the shear rate is a value calculated based on the total amount of ejection of the resin compositions during co-extrusion, the die width, and the lip opening. Accordingly, the shear stress during co-extrusion can be controlled by adjusting such each value. Specifically, the shear stress during co-extrusion is preferably 40 kPa or less, more preferably 38 kPa or less, and further preferably 36 kPa or less. The lower limit value is not particularly limited, but is preferably 5 kPa or more, and more preferably 10 kPa or more, in consideration of productivity and the like.

The drawdown ratio during co-extrusion is desirably low from the viewpoint of reducing the molecular orientation in the MD direction of the thermoplastic liquid crystal polymer during co-extrusion. When the drawdown ratio during co-extrusion is high, the thermoplastic liquid crystal polymer tends to be easily highly aligned in the MD direction and the internal strain tends to easily remain, and when the drawdown ratio during co-extrusion is low, the molecular orientation of the thermoplastic liquid crystal polymer tends to be easily reduced in both the film surface S1 and the film interior and the internal strain tends to hardly remain. The drawdown ratio is a value represented by the drawing speed (mm/sec)/the flow rate (mm/sec) of the thermoplastic liquid crystal polymer, and the flow rate of the thermoplastic liquid crystal polymer is a value calculated based on the total amount of ejection of the resin compositions during co-extrusion, the die width, and the lip opening. Accordingly, the drawdown ratio during co-extrusion can be controlled by adjusting such each value. Specifically, the drawdown ratio during co-extrusion is preferably 3.5 or less, more preferably 3.3 or less, and further preferably 3.1 or less. The lower limit value is not particularly limited, but is preferably 1.0 or more, and more preferably 1.2 or more, in consideration of productivity and the like.

The thickness of the LCP extruded film 100 to be obtained can be appropriately set depending on the desired performance, and is not particularly limited. Considering the handleability and the productivity during extrusion and the like, the thickness is preferably 15 μm or more and 300 μm or less, more preferably 18 μm or more and 250 μm or less, and further preferably 20 μm or more and 200 μm or less.

The melting point (melting temperature) of the obtained LCP extruded film 100 is not particularly limited, but the melting point (melting temperature) is preferably 200 to 400°C from the viewpoint of the heat resistance, processability, and the like of the film, and is preferably 250 to 360°C, more preferably 260 to 355°C, further preferably 270 to 350°C, and particularly preferably 275 to 345°C, from the viewpoint of especially increasing the thermocompression bonding properties to the metal foil. As used herein, to observe a value from which the thermal history has been eliminated, the melting point of LCP extruded film 100 refers to a melting peak temperature in differential scanning calorimetry (DSC) when the extruded film is heated at a temperature interval of 30 to 400°C and at a temperature rising rate of 20°C/min with DSC8500 (manufactured by PerkinElmer Japan Co., Ltd.) (1st heating), then cooled at a temperature decreasing rate of 50°C/min (1st cooling), and then heated for the second time at a temperature rising rate of 20°C/min (2nd heating).

Others are in accordance with the measurement conditions described in the Examples below.

The LCP extruded film 100, which is extruded, can be used as it is, but can be, if necessary, subjected to a pressurizing and heating step to result in further reduction in the orientation (anisotropy) or further relaxation of the internal strain, and thus the LCP extruded film 100, which is more reduced in anisotropy of the dimensional rate of change, and the LCP extruded film 100, which is lower in absolute value of the dimensional rate of change, can also be realized.

The heating and pressurizing treatment may be performed using a method known in the art such as contact type heat treatment and non-contact type heat treatment, and the type thereof is not particularly limited. Heat setting can be carried out using a known device such as a non-contact heater, an oven, a blowing apparatus, a heat roller, a cooling roller, a heat press, or a double belt heat press. At this time, heat treatment may be performed by placing a release film or a porous film known in the art on a surface of the LCP extruded film 100, if necessary. When this heat treatment is performed, thermocompression molding in which a release film or a porous film is placed on both surfaces of the LCP extruded film 100, which is subjected to thermocompression bonding by sandwiching it between a pair of endless belts of a double belt press, and then the release film or the porous film is removed is preferably used, from the viewpoint of controlling the alignment. Thermocompression molding may be performed with reference to, for example, Japanese Patent Laid-Open No. 2010-221694. The treatment temperature when the LCP extruded film 100 using the above resin composition is subjected to thermocompression molding between a pair of endless belts of a double belt press is preferably a temperature higher than the melting point of the liquid crystal polymer and not more than a temperature 70°C higher than the melting point, more preferably not less than a temperature +5°C higher than the melting point and not more than a temperature 60°C higher than the melting point, and further preferably not less than a temperature +10°C higher than the melting point and not more than a temperature 50°C higher than the melting point, to control the crystalline state of the LCP extruded film 100. The thermocompression bonding conditions can be appropriately set depending on the desired performance and are not particularly limited, but are preferably conditions of a surface pressure of 0.5 to 10 MPa and a heating temperature of 250 to 430°C, more preferably conditions of a surface pressure of 0.6 to 8 MPa and a heating temperature of 260 to 400°C, and further preferably conditions of a surface pressure of 0.7 to 6 MPa and a heating temperature of 270 to 370°C. On the other hand, when a non-contact heater or an oven is used, for example, thermocompression bonding is preferably performed under the conditions at 200 to 320°C for 1 to 20 hours.

(Insulating material for circuit substrate)

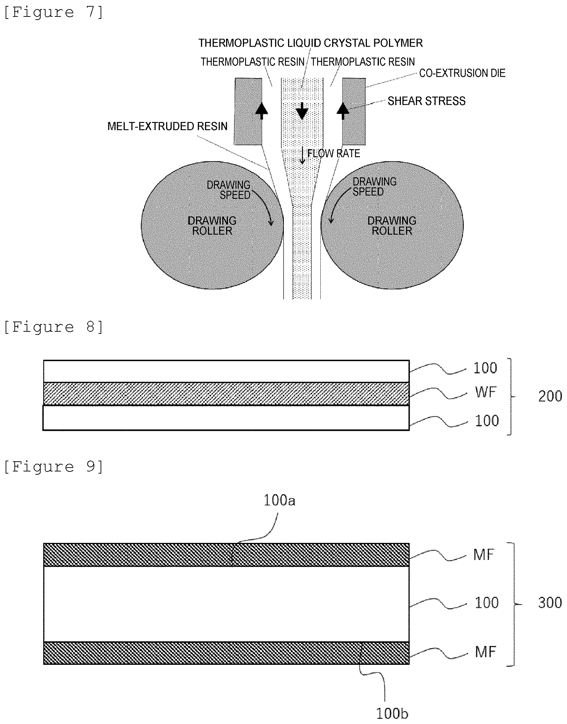

Figure 8 is a schematic cross-sectional view of a main portion of an insulating material 200 for a circuit substrate of the present embodiment. The insulating material 200 for a circuit substrate of the present embodiment comprises a laminate having at least the LCP extruded film 100 and a woven fabric WF provided on one surface and/or both surfaces of the LCP extruded film 100.

Specifically, the insulating material 200 for a circuit substrate comprises a laminate having a laminated structure (three layer structure) in which the LCP extruded film 100, the woven fabric WF and the LCP extruded film 100 are at least arranged in the listed order. In the laminate, one of these LCP extruded films 100 is provided on a front surface of the woven fabric WF and other of these LCP extruded films 100 is provided on a rear surface of the woven fabric WF. These three layers are thermocompression bonded and thus a laminate of the three layer structure is formed. While the laminate of the three layer structure is here exemplified, the present invention can be, of course, realized even by a laminate of a two layer structure in which one of these LCP extruded films 100 is omitted or a laminate of a laminated structure of four or more layers, in which the LCP extruded film 100 and/or woven fabric WF are/is further laminated.

As used herein, the "woven fabric WF provided on one surface and/or both surfaces of the LCP extruded film 100" encompasses not only an aspect in which the LCP extruded film 100 is placed directly on a surface of the woven fabric WF as in the present embodiment, but also an aspect in which any layers (not shown, e.g., primer layer and/or adhesive layer) are interposed between the LCP extruded film 100 and the woven fabric WF and thus the LCP extruded film 100 is located with being apart from the woven fabric WF.

The woven fabric WF is a fabric obtained by weaving a fiber. The type of the fiber of the woven fabric WF is not particularly limited, and any of an inorganic fiber, an organic fiber, or an organic/inorganic hybrid fiber can be used. In particular, a woven fabric WF of an inorganic fiber is preferably used. The woven fabric WF of an inorganic fiber can be thermocompression bonded with the LCP extruded film 100 to thereby allow the anisotropy of the dimensional rate of change in the MD direction and the TD direction to be kept small, and allow the dimensional rate of change in each of the MD direction and the TD direction, by itself, to be decreased in a further suitable aspect. A commercial product can be used for the woven fabric WF, and the woven fabric can be manufactured by a method known in the art.

Examples of the inorganic fiber include glass fibers such as E-glass, D-glass, L-glass, M-glass, S-glass, T-glass, Q-glass, UN-glass, NE-glass, and spherical glass, inorganic fibers other than glass, such as quartz, and ceramic fibers such as silica, but are not particularly limited thereto. The woven fabric WF of the inorganic fiber is suitably a woven fabric subjected to opening treatment or packing treatment, from the viewpoint of dimensional stability. Among these, a glass cloth is preferable from the viewpoint of mechanical strength, dimensional stability, water absorbability, and the like. A glass cloth subjected to opening treatment or packing treatment is preferable from the viewpoint of increasing the thermocompression bonding properties of the LCP extruded film 100. A glass cloth subjected to surface treatment with a silane coupling agent or the like, for example, epoxy silane treatment or amino silane treatment can also be suitably used. The woven fabric WF can be used singly or in appropriate combinations of two or more kinds thereof.

The thickness of the woven fabric WF can be appropriately set depending on the desired performance, and is not particularly limited. The thickness is preferably 10 to 300 $\mu$m, more preferably 10 to 200 $\mu$m, and further preferably 15 to 180 $\mu$m from the viewpoint of lamination ability, processability, mechanical strength, and the like.

The total thickness of the insulating material for a circuit substrate 200 can be appropriately set depending on the desired performance, and is not particularly limited. The total thickness is preferably 30 to 500 $\mu$m, more preferably 50 to 400 $\mu$m, further preferably 70 to 300 $\mu$m, and particularly preferably 90 to 250 $\mu$m from the viewpoint of lamination ability, processability, mechanical strength, and the like.

The insulating material 200 for a circuit substrate of the present embodiment, in which the above preferable configuration is adopted, thus has a significant effect in that the anisotropy of the dimensional rate of change in the MD direction and the TD direction is small and, in a further suitable aspect, the dimensional rate of change in each of the MD direction and the TD direction, by itself, can be decreased and furthermore the material is excellent in dielectric characteristics in a high frequency area, is easily manufactured and is excellent in productivity.

The insulating material 200 for a circuit substrate can be manufactured by appropriate application of a known production method, and the manufacturing method thereof is not particularly limited. As one example, the insulating material 200 for a circuit substrate can be obtained by laminating the LCP extruded film 100 and the woven fabric WF, and heating and pressurizing the resultant, to thereby thermocompression bond the LCP extruded film 100 and the woven fabric WF. A method is also preferable in which the LCP extruded film 100, the woven fabric WF and the LCP extruded film 100 are stacked in the listed order into a laminate and this laminate is heated and pressurized and subjected to thermocompression molding with being sandwiched by use of a press, a double belt press or the like to thereby provide the insulating material 200 for a circuit substrate. The processing temperature during thermocompression bonding can be appropriately set depending on the desired performance and is not particularly limited, but is preferably 200 to 400°C, more preferably 250 to 360°C, and further preferably 270 to 350°C. The processing temperature during thermocompression bonding is a value measured with the surface temperature of the LCP extruded film 100 of the laminate described above. The pressurizing conditions here can be appropriately set depending on the desired performance and are not particularly limited, but, are, for example, conditions of a surface pressure of 0.5 to 10 MPa and 1 to 240 minutes, more preferably conditions of a surface pressure of 0.8 to 8 MPa and 1 to 120 minutes.

(Metal foil-clad laminate)

Figure 9 is a schematic cross-sectional view of a main portion of a metal foil-clad laminate 300 of the present embodiment. The metal foil-clad laminate 300 of the present embodiment comprises the above LCP extruded film 100 and a metal foil MF provided on one surface and/or both surfaces of the LCP extruded film 100.

Specifically, the metal foil-clad laminate 300 is a double-sided metal foil-clad laminate having a laminated structure (three layer structure) in which the metal foil MF, the LCP extruded film 100, and the metal foil MF are at least arranged in the listed order. These three layers are thermocompression bonded and thus a laminate of the three layer structure is formed. While the double-sided metal foil-clad laminate is shown in the present embodiment, the present invention can also be realized as an aspect in which the metal foil MF is provided on only one surface of the LCP extruded film 100. In other words, while the laminate of the three layer structure is here exemplified, the present invention can be, of course, realized even by a laminate of a two layer structure in which one of these metal foils MF is omitted or a laminate of a laminated structure of four or more layers, in which the LCP extruded film 100 and/or the woven fabric WF are/is further laminated.

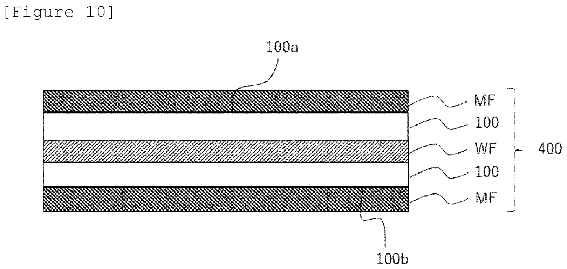

Figure 10 is a schematic cross-sectional view of a main portion of a metal foil-clad laminate 400 of the present embodiment. The metal foil-clad laminate 400 of the present embodiment comprises a laminate having at least the above LCP extruded film 100 and the above woven fabric WF provided on one surface and/or both surfaces of the LCP extruded film 100, and a metal foil MF provided on one surface and/or both surfaces of the laminate.

Specifically, the metal foil-clad laminate 400 is a double-sided metal foil-clad laminate having a laminated structure (five layer structure) in which the metal foil MF, the LCP extruded film 100, the woven fabric WF, the LCP extruded film 100, and the metal foil MF are at least arranged in the listed order. These five layers are thermocompression bonded and thus a laminate of the five layer structure is formed. While the double-sided metal foil-clad laminate is shown in the present embodiment, the present invention can also be realized as an aspect in which the metal foil MF is provided on only one surface. In other words, while the laminate of the five layer structure is here exemplified, the present invention can be, of course, realized even by a laminate of a four layer structure in which one of these metal foils MF is omitted or a laminate of a laminated structure of six or more layers, in which the LCP extruded film 100, the insulating material 200 for a circuit substrate, and/or the woven fabric WF are/is further laminated.

Examples of the material of the metal foil MF include, but are not particularly limited to, gold, silver, copper, copper alloy, nickel, nickel alloy, aluminum, aluminum alloy, iron, and iron alloy. Among these, a copper foil, an aluminum foil, a stainless steel foil, and an alloy foil of copper and aluminum are preferred, and a copper foil is more preferred. As such a copper foil, any one manufactured by a rolling method, an electrolysis method, or the like may be used, and electrolytic copper foil and rolled copper foil which have a relatively high surface roughness are preferred.

The thickness of the metal foils MF may be appropriately set in accordance with the desired performance, and is not particularly limited. Typically, the thickness is preferably 1.5 to 1,000 $\mu$m, more preferably 2 to 500 $\mu$m, further preferably 5 to 150 $\mu$m, and particularly preferably 7 to 100 $\mu$m. As long as the function and effect of the present invention are not impaired, the metal foils MF may be subjected to surface treatment such as chemical surface treatment such as acid washing. The types and the thicknesses of the metal foils MF may be the same as or different from each other.

The method for providing the metal foils MF on the surfaces of the LCP extruded film 100 and the insulating material for a circuit substrate 200 can be performed in accordance with a conventional method, and is not particularly limited. The method may be any one of methods in which the metal foils MF are laminated on the LCP extruded film 100 and the insulating material for a circuit substrate 200 and then both layers are adhered or pressure bonded, physical methods (dry method) such as sputtering and vapor deposition, chemical methods (wet method) such as electroless plating and electrolytic plating after electroless plating, and methods for applying a metal paste. The metal foil-clad laminates 300 and 400 can also be obtained by heat pressing a laminate in which the LCP extruded film 100 and the insulating material for a circuit substrate 200 and one or more metal foils MF are laminated, with, for example, a multi-stage press, a multi-stage vacuum press, a continuous molding machine, or an autoclave molding machine.

The metal foil-clad laminates 300 and 400 can be manufactured by appropriate application of a known production method, and the manufacturing method thereof is not particularly limited. As one example, a method is exemplified in which the LCP extruded film 100, the insulating material 200 for a circuit substrate and the metal foil MF are stacked into a laminate in which the metal foil MF is placed on the LCP extruded film 100 and this laminate is subjected to thermocompression molding with being sandwiched between a pair of endless belts of a double belt press. As described above, the LCP extruded film 100 to be used in the present embodiment is high in adhesiveness to metal foil and has high metal foil peel strength. The anisotropy of the dimensional rate of change in the MD direction and the TD direction is small and, in a further suitable aspect, the dimensional rate of change in each of the MD direction and the TD direction, by itself, is small and thus high peel strength to the metal foil MF is obtained.

The temperature during thermocompression bonding of the metal foils MF can be appropriately set depending on the desired performance, and is not particularly limited, but is preferably not less than a temperature 50°C lower than the melting point of the liquid crystal polymer and not more than a temperature 50°C higher than the melting point, more preferably not less than a temperature 40°C lower than the melting point and not more than a temperature 40°C higher than the melting point, further preferably not less than a temperature 30°C lower than the melting point and not more than a temperature 30°C higher than the melting point, and particularly preferably not less than a temperature 20°C lower than the melting point and not more than 20°C higher than the melting point. The temperature during thermocompression bonding of the metal foils MF is a value measured with the surface temperature of the LCP extruded film 100 of the above-described. The thermocompression bonding conditions at this time can be appropriately set in accordance with the desired performance, but is not particularly limited thereto. For example, when a double belt press is used, the thermocompression bonding is preferably performed under the conditions of surface pressure of 0.5 to 10 MPa and a heating temperature of 200 to 360°C.

The metal foil-clad laminates 300 and 400 of the present embodiment may have another laminated structure or a further laminated structure, as long as including a thermocompression bonded body of a two layer structure of the LCP extruded film 100, and the metal foils MF. The laminated structure may be a multilayer structure, for example, a two layer structure such as metal foil MF/LCP extruded film 100; a three layer structure such as metal foil MF/LCP extruded film 100/metal foil MF, or LCP extruded film 100/metal foil MF/LCP extruded film 100; a four layer structure such as metal foil MF/LCP extruded film 100/woven fabric WF/LCP extruded film 100; or a five layer structure such as metal foil MF/LCP extruded film 100/metal foil MF/LCP extruded film 100/metal foil MF, or metal foil MF/LCP extruded film 100/woven fabric WF/LCP extruded film 100/metal foil MF. Also, a plurality of metal foil-clad laminates 300 and 400 (e.g., 2 to 50 laminates) may be laminated and thermocompression bonded.

In the metal foil-clad laminates 300 and 400 of the present embodiment, the peel strength between the LCP extruded film 100 and the metal foils MF is not particularly limited, but is preferably 0.8 (N/mm) or more, more preferably 1.0 (N/mm) or more, and further preferably 1.2 (N/mm) or more, from the viewpoint of providing further high peel strength. As described above, since the metal foil-clad laminates 300 and 400 of the present embodiment can realize high peel strength, for example, peeling between the LCP extruded film 100 and the metal foils MF can be suppressed in the heating step during manufacture of a substrate. In addition, since manufacturing conditions for excellent process tolerance and productivity can be applied to obtain the same peel strength as the conventional technique, the deterioration of the basic performance possessed by the liquid crystal polymer can be suppressed, while the same degree of peel strength as the conventional metal foil-clad laminate is maintained.

The metal foil-clad laminates 300 and 400 of the present embodiment can be used as a raw material for circuit substrates such as electronic circuit substrates or multilayer substrates, by performing pattern etching on at least a part of the metal foils MF. The metal foil-clad laminates 300 and 400 of the present embodiment, since having excellent dielectric characteristics in a high frequency area and being small in anisotropy of the dimensional rate of change in the MD direction and the TD direction, and, in a further suitable aspect, being small in dimensional rate of change in each of the MD direction and the TD direction, by itself, having excellent dimensional stability, being easily manufactured and having excellent productivity, are especially useful raw materials as insulating materials for flexible printed wiring boards (FPC) and the like in the fifth-generation mobile communication system (5G), millimeter wave radar, and the like.

Examples

The feature of the present invention will be further described in detail below by way of Examples and Comparative Examples, but the present invention is not limited thereto in any way. That is, the materials, amounts used, proportions, contents of treatment, treatment procedures, and the like presented in the following Examples can be appropriately modified without departing from the gist of the present invention. The values of various manufacturing conditions and evaluation results in the following Examples have a meaning as a preferred upper limit value or a preferred lower limit value in the embodiment of the present invention, and the preferred numerical value range may be a range defined by a combination of the upper limit value or the lower limit value and the values of the following Examples or a combination of values in Examples.

[Melt viscosity]

The melt viscosity [Pa·sec] of each LCP extruded film was measured under the following conditions.

Measurement device: Capilograph 1D (manufactured by Toyo Seiki Seisaku-sho, Ltd.)
Apparatus used: cylinder length 10.00 mm, cylinder diameter 1.00 mm, barrel diameter 9.55 mm
Measurement conditions: temperature [°C] and shear rate [sec$^{-1}$] in extrusion of each LCP extruded film

[Contact angle and rate of decrease]

The contact angle $\sigma_1$ (after one day from constant temperature and humidity treatment at 23°C and 50% RH) and the contact angle $\sigma_7$ (after 7 days from constant temperature and humidity treatment at 23°C and 50% RH), of the film surface S1 of the LCP extruded film, with water, were each determined by using an automatic contact angle meter (DMC-MC3, manufactured by Kyowa Interface Science Co., Ltd.), dropping distilled water (amount of liquid 4 $\mu$L) as a measurement liquid, onto the film surface S1 of the LCP extruded film 100, under the environment at 23°C and 50% RH, and measuring the contact angle after 3 seconds from the dropping, based on a tangent method. The rate of decrease ($(\sigma_7 - \sigma_1)/\sigma_1$) of the contact angle $\sigma_7$ relative to the contact angle $\sigma_1$ was also calculated based on the resulting measurement results.

[Peel strength]

The copper foil peel strength of a flexible laminate was measured under the following conditions. An electrolytic copper foil (TQ-M7VSP manufactured by Mitsui Kinzoku) having a thickness of 12 $\mu$m was laminated on one surface of each LCP extruded film stored under the environment at 23°C and 50% RH for 7 days, and subjected to thermocompression bonding under a condition of a temperature lower than the melting point of the thermoplastic liquid crystal polymer film, by 10°C, at a surface pressure of 5 MPa for 1 minute, to thereby produce each metal foil-clad laminate (flexible laminate) having a two layer configuration of the LCP extruded film and the copper foil. A test piece having a width of 10 mm was cut out to a strip shape from the resulting flexible laminate, and the copper foil peel strength was measured with Strograph VE1D (manufactured by Toyo Seiki Seisaku-sho, Ltd.) by peeling in a 180-degree direction at a tensile speed of 50 mm/min under the environment at a temperature of 23°C and 50% RH, and evaluated according to the following criteria.

A: material breakage at 1.0 N/mm or more
C: less than 1.0 N/mm

[Hardness measurement according to nanoindentation method]

The hardness H1 at a point of a depth of 1 $\mu$m and the hardness H2 at the thickness center point, of each LCP extruded film stored under the environment at 23°C and 50% RH for 7 days, were measured by a nanoindentation method according to ISO 14577.

Measurement device: nanoindenter Hysitron TI 950 TriboIndenter (manufactured by Bruker)
Indenter used: diamond Berkovich indenter
Measurement conditions: indentation depth hmax 0.05 $\mu$m
Measurement method: loading-unloading test

The measurement surface of each LCP extruded film was defined as a film smooth cross section in parallel with the MD direction of each of the LCP extruded films, and such a film smooth cross section was produced by cutting and processing each LCP extruded film by ion beam processing under freezing conditions.

[Coefficient of linear thermal expansion]

The coefficient of linear thermal expansion of each LCP extruded film stored under the environment at 23°C and 50% RH for 7 days was measured by a TMA method according to JIS K7197.

Measurement device: TMA 4000SE (manufactured by NETZSCH Japan K.K.)
Measurement method: tension mode
Measurement conditions: sample size 25 mm $\times$ 4 mm $\times$ thickness: 50 $\mu$m
distance between chucks: 20 mm
temperature interval: 23 to 200°C (2nd RUN)
temperature rising rate: 5°C/min
atmosphere: nitrogen (flow rate: 50 ml/min)
test load: 5 gf

**[0095]** * To observe a value from which the thermal history has been eliminated, the value at 2nd RUN was employed

[Degree of alignment]

X-ray diffraction measurement of each LCP extruded film stored under the environment at 23°C and 50% RH for 7 days was performed as follows. Each LCP extruded film comprising the film surface S1 or the film surface S2 was subjected to X-ray diffraction measurement with an X-ray diffraction apparatus Smartlab (manufactured by Rigaku Corporation) by a transmission method, and the degree of alignment was thus measured. Here, X-ray diffraction measurement ($2\theta/\theta$ scan, $\beta$ scan) was performed with a Cu sealed tube as an X-ray source in a parallel beam optical system by a transmission method, and it was first confirmed by $2\theta/\theta$ scan that a peak top was present at $2\theta$ = 19.5°. Next, the intensity of a diffraction peak at $2\theta$ = 19.5 was measured at 0° to 360° in the bearing angle direction by $\beta$ scan, and thus an intensity distribution in the bearing angle direction was obtained. The degree of alignment was calculated from the above expression based on the alignment peak area ratio from the base intensity (isotropic component) and the peak intensity (alignment component) of the resulting $\beta$ profile.

The film surface S2 of each LCP extruded film was here adjusted by immersing each LCP extruded film in an aqueous 70% monoethylamine solution (manufactured by Daicel Corporation) under the environment at 23°C and 50% RH for 168 hours, etching both surfaces of each LCP extruded film, by 5 $\mu$m, thereafter washing them with flowing water for 5 minutes and furthermore distilled water, and subjecting the resultant to drying at 80°C for 1 hour and cooling under the environment at 23°C and 50% RH for 24 hours.

[Tape release test]

The film surface S1 of each LCP extruded film stored under the environment at 23°C and 50% RH for 7 days was subjected to an adhesiveness test by a cross-cutting method according to JIS K5600-5-6 and the presence of a skin layer therein was confirmed. Here, Cellotape (R) of 24 mm width $\times$ 50 mm length, manufactured by Nichiban Co., Ltd., was used, and a case of no peeling on the mesh of grid after tape release was defined as "Skin layer absent" and a case of peeling thereon was defined as "Skin layer present".

A: skin layer absent

C: skin layer present

[Dimensional rate of change after etching of metal foil, and anisotropy thereof]

An electrolytic copper foil (TQ-M7VSP manufactured by Mitsui Kinzoku) having a thickness of 12 $\mu$m was laminated on both surface of each LCP extruded film stored under the environment at 23°C and 50% RH for 7 days, and subjected to thermocompression bonding under a temperature condition of 320°C at a surface pressure of 1 MPa for 1 minute, to thereby produce each double-sided metal foil-clad laminate having a three layer configuration of copper foil/LCP extruded film/copper foil. Each sample was prepared from such each double-sided metal foil-clad laminate obtained, according to JPCA-UB01(2017) and "16.4.4-18 dimensional rate of change" and "16.4.4-2-2 production of sample by removal of copper foil" of the same standard, the dimensional rate of change after etching of the copper foil of such each sample was measured with a measurement microscope (MF-A4020C manufactured by Mitutoyo Corporation), and the anisotropy of the dimensional rate of change was evaluated. Here, $\beta_1$ represents the dimensional rate of change in the MD direction and $\beta_2$ represents the dimensional rate of change in the TD direction.

S: very small anisotropy of dimensional rate of change ($|\beta_2 - \beta_1| \leq 0.3\%$)
A: small anisotropy of dimensional rate of change ($0.3\% < |\beta_2 - \beta_1| < 0.4\%$)
C: large anisotropy of dimensional rate of change ($0.40 \leq |\beta_2 - \beta_1|$)

(Example 1)

A type II thermoplastic liquid crystal polymer (copolymer having a monomer composition of 74 mol% of p-hydroxybenzoic acid and 26 mol% of 6-hydroxy-2-naphthoic acid, and having a melt viscosity at a temperature of 300°C and a shear rate of 500 sec$^{-1}$, of 80 Pa·sec) and polycarbonate PC (301-15 manufactured by Sumika Polycarbonate Limited) were used respectively in an intermediate layer and each outer layer of both surfaces of the intermediate layer, such respective resins were co-extruded at 300°C from a two-kind three layer extruder provided with a T-die having a die width of 600 mm and a lip opening of 0.2 to 1.0 mm, according to a T-die casting method under molding conditions shown in Table 1, and thus a two-kind three layer film in which the thickness of the intermediate layer was 50 $\mu$m was formed. Polycarbonate films on both outer layers of the two-kind three layer film formed were each released by a winding line, and an LCP extruded film of Example 1, having a melting point of 280°C and a thickness of 50 $\mu$m, was obtained. While a glass cloth (IPC No. #1037) was sandwiched between a pair of thermoplastic liquid crystal polymer films obtained of Example 1, thermocompression bonding treatment with a heat press was performed at 300°C for 5 minutes and thus an insulating material for a circuit substrate, having a melting point of 280°C and a total thickness of 100 $\mu$m, of Example 1 was obtained.

(Example 2)

An LCP extruded film of Example 2, having a melting point of 280°C and a thickness of 50 $\mu$m, and an insulating material for a circuit substrate, of Example 2, having a melting point of 280°C and a total thickness of 100 $\mu$m were obtained in the same manner as in Example 1 except that polybutylene terephthalate PBT (5010R3-2NA manufactured by Mitsubishi Engineering-Plastics Corporation) was used in each outer layer of both surfaces of the intermediate layer, instead of polycarbonate PC (301-15 manufactured by Sumika Polycarbonate Limited).

(Example 3)

An LCP extruded film of Example 3, having a melting point of 280°C and a thickness of 50 $\mu$m, and an insulating material for a circuit substrate, of Example 3, having a melting point of 280°C and a total thickness of 100 $\mu$m were obtained in the same manner as in Example 1 except that polyamide resin PA (M1040E-N manufactured by Unitika Ltd.) was used in each outer layer of both surfaces of the intermediate layer, instead of polycarbonate PC (301-15 manufactured by Sumika Polycarbonate Limited).

(Reference Example 1)

A type II thermoplastic liquid crystal polymer (copolymer having a monomer composition of 74 mol% of p-hydroxybenzoic acid and 26 mol% of 6-hydroxy-2-naphthoic acid, and having a melt viscosity at a temperature of 300°C and a shear rate of 500 sec$^{-1}$, of 80 Pa·sec) was used, and the liquid crystal polymer was extruded at 300°C from a single layer extruder provided with a T-die having a die width of 600 mm and a lip opening of 0.3 mm, according to a T-die casting method under molding conditions shown in Table 1, and thus an LCP extruded film of Reference Example 1, having a melting point of 280°C and a thickness of 50 μm, and an insulating material for a circuit substrate, of Reference Example 1, having a melting point of 280°C and a total thickness of 100 μm were obtained.

(Reference Example 2)

A film surface of the LCP extruded film of Reference Example 1 was subjected to corona discharge treatment (TEC-4AX manufactured by Kasuga Denki, Inc., 0 m treatment width × 1.0 m/min line speed, output 36 w, amount of discharge 120 w·min/m²), and thus an LCP extruded film of Reference Example 2, having a melting point of 280°C and a thickness of 50 μm, and an insulating material for a circuit substrate, of Reference Example 2, having a melting point of 280°C and a total thickness of 100 μm were obtained.

(Comparative Example 1)

An LCP extruded film of Comparative Example 1, having a melting point of 280°C and a thickness of 50 μm, and an insulating material for a circuit substrate, of Comparative Example 1, having a melting point of 280°C and a total thickness of 100 μm were obtained in the same manner as in Example 1 except that polymethylpentene PMP (TPX MX004 manufactured by Mitsui Chemical Inc.) was used in each outer layer of both surfaces of the intermediate layer, instead of polycarbonate PC (301-15 manufactured by Sumika Polycarbonate Limited).

(Comparative Example 2)

An LCP extruded film of Comparative Example 2, having a melting point of 280°C and a thickness of 50 μm, and an insulating material for a circuit substrate, of Comparative Example 2, having a melting point of 280°C and a total thickness of 100 μm were obtained in the same manner as in Example 1 except that high-density polyethylene HDPE (HF-313 manufactured by Mitsubishi Chemical Corporation) was used in each outer layer of both surfaces of the intermediate layer, instead of polycarbonate PC (301-15 manufactured by Sumika Polycarbonate Limited).

[Table 1]

Table 1

| | Film formation method | Intermed iate layer LCP | Thermopl astic resin (release layer) of both surface layers | Film formation conditions | |
| --- | --- | --- | --- | --- | --- |
| | | | | Shear stress [kPa] | Drawdown ratio |
| Reference Example 1 | Single layer | Type II | - | 45 | 3.8 |
| Reference Example 2 | Single layer (Physical surface treatment) | Type II | - | 45 | 3.8 |
| Example 1 | Release of two-kind three layers | Type II | PC | 10 | 1.5 |
| Example 2 | Release of two-kind three layers | Type II | PBT | 10 | 1.5 |
| Example 3 | Release of two-kind three layers | Type II | PA | 10 | 1.5 |
| Comparative Example 1 | Release of two-kind three layers | Type II | PMP | 10 | 1.5 |
| Comparative Example 2 | Release of two-kind three layers | Type II | HDPE | 10 | 1.5 |

Table 2 and Table 3 show measurement results of various performances.

[Table 2]

Table 2

| | Contact angle [°] | | Rate of decrease [%] in contact angle $((\sigma_7 - \sigma_1)/\sigma_1)$ | Peel strength |
|---|---|---|---|---|
| | $\sigma_1$ after lapse of 1 day | $\sigma_7$ after lapse of 7 days | | |
| Reference Example 1 | 85 | 85 | 0.0 | C |
| Reference Example 2 | 65 | 80 | 23.1 | C |
| Example 1 | 70 | 75 | 7.1 | A |
| Example 2 | 70 | 75 | 7.1 | A |
| Example 3 | 70 | 75 | 7.1 | A |
| Comparative Example 1 | 85 | 85 | 0.0 | C |
| Comparative Example 2 | 85 | 85 | 0.0 | C |

[Table 3]

Table 3

| | Hardness [GPa] of cross section in parallel with MD direction | | | Coefficient [ppm/K] of linear thermal expansion | | Presence of skin layer | Dimensional rate of change [%] after etching of copper foil | | |
|---|---|---|---|---|---|---|---|---|---|
| | H1 at point of depth of 1 $\mu$m from film surface | H2 at thickness center point | (H2-H1) /H1×100 | MD direction | TD direction | | MD direction $\beta_1$ | TD direction $\beta_2$ | $\lvert \beta_2-\beta_1 \rvert$ |
| Reference Example 1 | 0.242 | 0.209 | -13.6 | -20 | 61 | Present | 0.2 | -0.6 | 0.8 |
| Reference Example 2 | 0.242 | 0.209 | -13.6 | -20 | 61 | Present | 0.2 | -0.6 | 0.8 |
| Example 1 | 0.272 | 0.266 | -2.2 | -18 | 24 | Absent | 0.0 | -0.1 | 0.1 |
| Example 2 | 0.275 | 0.269 | -2.2 | -17 | 21 | Absent | 0.0 | -0.1 | 0.1 |
| Example 3 | 0.269 | 0.261 | -3.0 | -19 | 28 | Absent | -0.1 | -0.2 | 0.1 |
| Comparative Example 1 | 0.275 | 0.266 | -3.3 | -17 | 21 | Absent | -0.1 | -0.2 | 0.1 |
| Comparative Example 2 | 0.271 | 0.262 | -3.3 | -18 | 26 | Absent | -0.1 | -0.2 | 0.1 |

[Table 4]

Table 4

| | Degree of alignment [%] | | |
|---|---|---|---|
| | $\alpha_1$ before etching treatment | $\alpha_2$ after etching treatment | $(\alpha_2-\alpha_1)/\alpha_1 \times 100$ |
| Reference Example 2 | 39.9 | 38.0 | -4.8 |
| Reference Example 1 | 39.9 | 38 | -4.8 |
| Example 1 | 34.7 | 34.4 | -0.9 |
| Example 2 | 34.2 | 34.0 | -0.6 |
| Example 3 | 35.2 | 34.9 | -0.9 |
| Comparative Example 1 | 34.2 | 33.9 | -0.9 |
| Comparative Example 2 | 35.0 | 34.6 | -1.1 |

Industrial Applicability

The LCP extruded film of the present invention can be widely and effectively utilized in applications such as electronic circuit substrates, multilayer substrates, high heat radiation substrates, flexible printed wiring boards, antenna substrates, optoelectronic hybrid substrates, and IC packages, and since being especially adapted to ultrafine processing and having high reliability, the LCP extruded film of the present invention can be especially widely and effectively utilized as an insulating material or a metal foil-clad laminate for flexible printed wiring boards (FPC) and the like in the fifth-generation mobile communication system (5G), millimeter wave radar, and the like.

Reference Signs List

100 LCP extruded film
100a surface
100b surface
H1 hardness at point of depth of 1 $\mu$m
H2 hardness at thickness center point
S1 film surface
S2 film surface at depth of 5 $\mu$m
200 insulating material for circuit substrate
300 metal foil-clad laminate
400 metal foil-clad laminate
WF woven fabric
MF metal foil

**Claims**

1. An LCP extruded film having a film surface S1 and comprising a thermoplastic liquid crystal polymer, wherein a contact angle $\sigma_1$ of the film surface S1 of the LCP extruded film with water after one day from constant temperature and humidity treatment at 23°C and 50% RH is 60° or more and 80° or less, a contact angle $\sigma_7$ of the film surface S1 of the LCP extruded film with water after 7 days from constant temperature and humidity treatment at 23°C and 50% RH is 60° or more and 80° or less, and a rate of decrease $((\sigma_7 - \sigma_1)/\sigma_1)$ of the contact angle $\sigma_7$ relative to the contact angle $\sigma_1$ is 10.0% or less.

2. The LCP extruded film according to claim 1, wherein coefficients of linear thermal expansion in a MD direction and a TD direction of the LCP extruded film are each within a range of -30 to 55 ppm/K.

3. The LCP extruded film according to claim 1 or 2, wherein the film is an intermediate layer obtained by removing both outer layers from a laminated extruded film having the outer layer, the intermediate layer, and the outer layer.

4. The LCP extruded film according to any one of claims 1 to 3, wherein the film surface S1 is subjected to no physical surface treatment.

5. The LCP extruded film according to any one of claims 1 to 4, wherein

   the film has a thickness of 15 $\mu$m or more and 300 $\mu$m or less, and
   a hardness H1 at a point of a depth of 1 $\mu$m located at a position of 1 $\mu$m from the film surface S1 in a thickness direction and a hardness H2 at a thickness center point, as measured by subjecting a film cross section in parallel with a MD direction to a nanoindentation method, satisfy $-10.0 \leq 100 \times (H2-H1)/H1 \leq 0.0$, and coefficients of linear thermal expansion in a MD direction and a TD direction of the LCP extruded film at 23 to 200°C as measured by a TMA method according to JIS K7197 are each within a range of -30 to 55 ppm/K.

6. The LCP extruded film according to any one of claims 1 to 5, wherein the coefficient of linear thermal expansion in the TD direction of the LCP extruded film is 0 to 55 ppm/K.

7. The LCP extruded film according to any one of claims 1 to 6, wherein the film surface S1 does not have any skin layer that is peelable by a tape in an adhesiveness test by a cross-cutting method according to JIS K5600-5-6.

8. The LCP extruded film according to any one of claims 5 to 7, wherein the hardness H2 at the thickness center point is 0.240 (GPa) or more.

9. The LCP extruded film according to any one of claims 5 to 8, wherein the hardness H1 at the point of a depth of 1 $\mu$m is 0.250 (GPa) or more.

10. The LCP extruded film according to any one of claims 1 to 9, further containing an inorganic filler.

11. The LCP extruded film according to any one of claims 1 to 10, wherein the LCP extruded film is a T-die extruded film.

12. An insulating material for a circuit substrate, comprising a laminate having at least the LCP extruded film according to any one of claims 1 to 11 and a woven fabric provided on at least one surface of the LCP extruded film.

13. A metal foil-clad laminate comprising the LCP extruded film according to any one of claims 1 to 11 and metal foil provided on one surface and/or both surfaces of the LCP extruded film.

14. A metal foil-clad laminate comprising a laminate having at least the LCP extruded film according to any one of claims 1 to 11 and a woven fabric, and metal foil provided on one surface and/or both surfaces of the laminate.

15. A method for manufacturing an LCP extruded film, comprising at least

   a step of co-extruding a resin composition for a first outer layer comprising one or more thermoplastic resins selected from the group consisting of a (meth)acrylic resin, a polyamide resin, polybutylene terephthalate, polyethylene terephthalate, polycarbonate, polyether ether ketone, and polyphenyl sulfide, a resin composition for an intermediate layer comprising a thermoplastic liquid crystal polymer, and a resin composition for a second outer layer comprising one or more thermoplastic resins selected from the group consisting of a (meth)acrylic resin, a polyamide resin, polybutylene terephthalate, polyethylene terephthalate, polycarbonate, polyether ether ketone, and polyphenyl sulfide, to obtain a co-extruded film having a laminated structure in which a first outer layer, an intermediate layer, and a second outer layer are arranged at the listed order, and
   a step of removing the first outer layer and the second outer layer from the co-extruded film to obtain the intermediate layer comprising the thermoplastic liquid crystal polymer, wherein,
   in the step of obtaining the intermediate layer, an LCP extruded film having a film surface S1 is obtained, in which a contact angle $\sigma_1$ of the film surface S1 of the LCP extruded film with water after one day from constant temperature and humidity treatment at 23°C and 50% RH is 60° or more and 80° or less, a contact angle $\sigma_7$ of the film surface S1 of the LCP extruded film with water after 7 days from constant temperature and humidity treatment at 23°C and 50% RH is 60° or more and 80° or less, and a rate of decrease $((\sigma_7-\sigma_1)/\sigma_1)$ of the contact angle $\sigma_7$ relative to the contact angle $\sigma_1$ is 10.0% or less.

[Figure 1]

[Figure 2]

LOAD-DISPLACEMENT CURVE

[Figure 3]

[Figure 4]

## β PROFILE

[Figure 5]

[Figure 6]

[Figure 7]

[Figure 8]

[Figure 9]

[Figure 10]

## INTERNATIONAL SEARCH REPORT

International application No.

**PCT/JP2022/032930**

### A. CLASSIFICATION OF SUBJECT MATTER

**B32B 27/12**(2006.01)i; **C08J 5/18**(2006.01)i; **B32B 15/08**(2006.01)i; **B29C 48/21**(2019.01)i; **B29C 48/25**(2019.01)i; **H05K 1/03**(2006.01)i

FI: C08J5/18 CFD; B32B27/12; B32B15/08 Z; B29C48/21; B29C48/25; H05K1/03 610H

According to International Patent Classification (IPC) or to both national classification and IPC

### B. FIELDS SEARCHED

Minimum documentation searched (classification system followed by classification symbols)

B32B27/12; C08J5/18; B32B15/08; B29C48/21; B29C48/25; H05K1/03

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 8-302208 A (UNITIKA CHEM KK) 19 November 1996 (1996-11-19)<br>claims, examples | 1, 3-4, 11 |
| A | JP 2017-192875 A (UNIV FUKUOKA) 26 October 2017 (2017-10-26)<br>entire text, all drawings | 1-15 |
| A | JP 2019-218485 A (UNIV OSAKA) 26 December 2019 (2019-12-26)<br>entire text, all drawings | 1-15 |
| A | JP 2018-154409 A (TOYO SEIKAN GROUP HOLDINGS LTD) 04 October 2018 (2018-10-04)<br>entire text, all drawings | 1-15 |

☐ Further documents are listed in the continuation of Box C.　　☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **20 October 2022** | **15 November 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2022/032930**

| Patent document cited in search report | | | Publication date (day/month/year) | Patent family member(s) | Publication date (day/month/year) |
|---|---|---|---|---|---|
| JP | 8-302208 | A | 19 November 1996 | (Family: none) | |
| JP | 2017-192875 | A | 26 October 2017 | (Family: none) | |
| JP | 2019-218485 | A | 26 December 2019 | (Family: none) | |
| JP | 2018-154409 | A | 04 October 2018 | (Family: none) | |

Form PCT/ISA/210 (patent family annex) (January 2015)

**REFERENCES CITED IN THE DESCRIPTION**

**Patent documents cited in the description**

- JP 63031729 A

- JP 2010221694 A